# EUROPEAN PATENT APPLICATION

(11) **EP 1 261 242 A1**
(43) Date of publication of application: **27.11.2002**
(21) Application number: 01981091.0
(22) Date of filing: 13.11.2001
(51) Int. Cl.: H05K 3/00, H05K 3/46, B32B 15/08

(54) **METHOD FOR MANUFACTURING CIRCUIT BOARD**

(30) Priority: 15.11.2000 JP 2000347800
(71) Applicant: MATSUSHITA ELECTRIC INDUSTRIAL CO., LTD., Kadoma-shi, Osaka 571-8501 (JP)
(72) Inventor: TATSUMI, Kiyohide, Ikoma-shi, Nara 630-0254 (JP); NISHII, Toshihiro, Hirakata-shi, Osaka 573-0163 (JP); NAKAMURA, Shinji, Katano-shi, Osaka 576-0014 (JP)
(74) Representative: Grünecker, Kinkeldey, Stockmair & Schwanhäusser Anwaltssozietät
(86) International application number: JP0109907
(87) International publication number: WO02041675

(57) **Abstract**

A method of manufacturing circuit board comprising: holding a laminate with metal foil or resin-coated metal foil disposed on both surfaces or on one surface of board material or board material with metal foil circuit formed thereon between metal plates, and applying at least one of heat and pressure to the laminate. A hard coat layer formed on both surfaces or on one surface of the metal plate protects the metal plate. Accordingly, the metal plate is hardly scratched by its contact with the conveyor and the like or by handling by the operator during the production of the circuit boards. Further, since the hard coat layer surface is smoothly finished, resin or contamination sticking to the metal plate can be easily removed, thereby prolonging the life of the metal plate. As a result, it is possible to produce high-quality circuit boards at low costs.

## Description

### TECHNICAL FIELD

The present invention relates to a method of manufacturing a circuit board.

### BACKGROUND ART

With a recent trend of electronic equipment becoming miniaturized and higher in density, double-sided circuit boards and multi-layered circuit boards instead of conventional single-sided circuit boards are increasingly employed as circuit boards on which electronic components are mounted, and it gives rise to the development of high density circuit boards capable of integrating as many circuits as possible thereon.

In a high density circuit board, the design rules for circuits are more stringent than in a conventional circuit board. Accordingly, efforts are continued to make technical development with respect to finishing techniques for forming finer circuits, techniques for interstitial circuit connection in multi-layered circuit board or for through-hole and via-hole aligning, and techniques for interstitial circuit connection in smaller pitches.

Further, as the design rules for circuits are becoming more detailed and minute, it is necessary to make it easier to form fine circuit patterns by reducing the thickness of metal foil for forming the circuit. And it is also necessary to decrease the weight of circuit for the purpose of using it in a mobile electronic apparatus such as portable electronic equipment.

In the ordinary method of manufacturing a circuit boards, the method comprises: sandwiching a B stage prepreg sheet made by impregnating woven or non-woven fabric made of glass fiber or aramid fiber with thermosetting resin between two sheets of copper foils; further sandwiching the sandwiched laminate between metal plates disposed top and bottom; heat press the further sandwiched laminate to forming a unitary laminate; and forming a desired circuit pattern by etching the copper foils to obtain a circuit board.

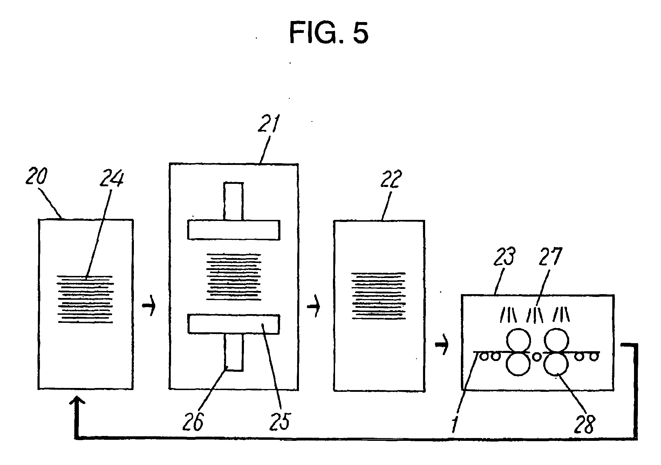

Fig. 5 is a schematic diagram of a conventional circuit board manufacturing method using a hot press as a major unit. First, prepreg sheet held between metal foils and further sandwiched between metal plates at a top and bottom thereof, or laminate 24, is placed in assembly unit 20.

The laminate 24 is usually stacked with a few or more than 10 laminates, each comprising board material and copper foils sandwiched between metal plates disposed on top and bottom thereof, to improve the productivity.

Next, the laminate 24 is moved into hot press unit 21 and is placed between top and bottom hot platens 25 to be heated and pressed. Inside the hot platens 25 is disposed hot oil or steam piping for heating the laminate 24.

Also, hydraulic cylinder 26 is supplied with high pressure oil to apply an appropriate pressure to the laminate 24.

The heating and pressing process is usually called a heat press process, where B-stage resin in the prepreg sheet melts and cures to adher the copper foils, to be formed into a shape as a circuit board.

Next, the laminate 24 is moved to disassembly unit 22 and is separated into metal plate and board material with copper foil adhered thereto. After that, the board material is delivered to the circuit forming process for forming the desired circuit, and the metal plate is delivered to and cleaned at cleaning device 23 and then to the re-assembly unit to be sequentially used in the next heat press process.

However, in this heat press process, there arise problems that the copper foils may break under heat and pressure in case such as foreign matter is clogged between the metal plate and copper foils, and fine scratches or projections exist on the metal plate surface, causing the resin in the prepreg leak out and stubbornly stick to the metal plate.

Particularly, as a recent trend, very thin copper foils are commonly used to make fine patterns for a high density circuit board. This tendency promotes the above problem.

Also, leaked out resin naturally sticks to the copper foil surface as well, and it is unable to etch the portion in the circuit forming process, resulting in generation of defective circuit patterns.

Further, besides the above problems, there is also a problem that B-stage resin falls from the end of prepreg sheet and becomes dust in the process and the molten dust stubbornly sticks to the metal plate surface.

The main role of the cleaning device 23 is to scribe away the sticking resin from the metal plate surface and to smoothen the metal plate surface by removing scratches or projections therefrom, thereby keeping the metal plate surface clean at all times.

In order to achieve the purpose, the cleaning device 23 is, as shown in the figure, provided with a water shower 27 and rotary polishing buff 28, which polishes and cleans the surfaces of metal plates sequentially passed through.

The polishing buff 28 is a brush or roll-form wheel made of synthetic fiber or the like with abrasive grain bonded to the surface thereof and serves to remove sticking matter while polishing the metal plate surface.

Since the polishing ability varies with the size of the abrasive grain, the grade of polishing buff is expressed by grain number, and when used for metal plate cleaning, those ranging from 300 to 600 are usually employed.

However, since the polishing operation grinds and removes not only the contamination but also the surface of the metal plate as well, the metal plate is reduced in thickness through repetition of polishing operation and becomes unable to be used for the production of the circuit board, then it is necessary to replace the metal plate with new one.

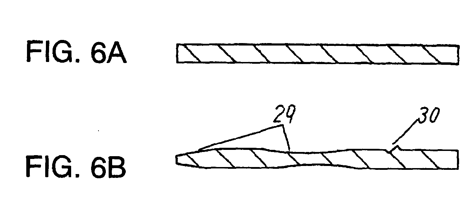

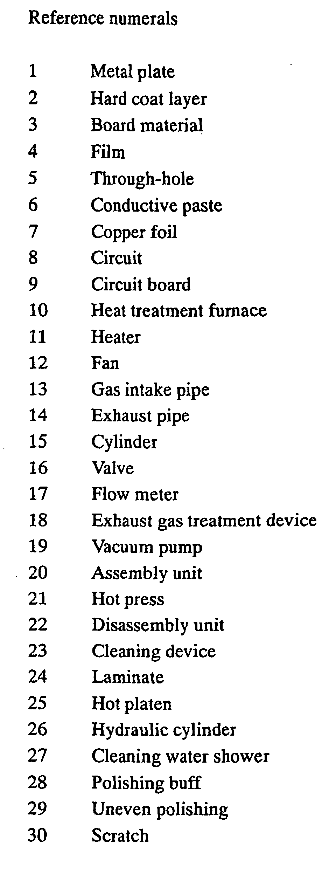

Also, in such polishing operation, it is difficult to uniformly polish the entire surface of the metal plate by equal amount, and in a case when a maintenance of the polishing machine or the polishing means such as the buff or a brush in the polishing machine is not sufficiently executed, unevenly polished surface 29 as shown in Fig. 6B will be generated on the surface of the metal plate which is initially uniform in thickness as shown in Fig. 6A, thereby causing the metal plate to have an uneven thickness.

If a circuit board is manufactured by using such metal plate with variations in thickness, the circuit board manufactured will become uneven in thickness as a matter of course.

As for recent circuit boards, the allowable range is becoming very severe with respect to uneven thickness of board to control a circuit impedance within a desired value or to be used in a thin electronic equipment. And in a case when the circuit board is greatly uneven in thickness, a quality of the circuit board is not sufficient.

Also, the conveyance of metal plates in the manufacturing process is automated by using a conveyor or the like, but there exists a problem that a scratch 30, as shown in Fig. 6B, is generated during in contact with rollers or the like of the conveyor unit, or, given by the operators during the operation.

### DISCLOSURE OF THE INVENTION

The method of manufacturing circuit board of the present invention includes a heat press process in which a laminate with metal foil(s) disposed on both surfaces or on one surface of a board material made of at least one kind of material or a board material with metal foil circuit formed thereon is placed between metal plates and subjected to a heat press process at least under heat or pressure, wherein a hard coat layer is formed on both surfaces or one surface of the metal plates.

According to the present invention, since the metal plate is protected by the hard coat layer, the metal plate is hardly scratched by a contact with the conveyor and the like or by the operator's handling during the production of the circuit boards. Further, finishing of the surface of the hard coat layer as smooth as possible makes it possible to easily remove resin or contamination sticking to the metal plate, to lessen the abrasion of the metal plate even when the conventional polishing method is applied, and to prolong the life of the metal plate. As a result, it is possible to produce the high-quality circuit boards at low costs.

### BRIEF DESCRIPTION OF THE DRAWINGS

Fig. 1 is a sectional view showing a metal plate used in the circuit board manufacturing method in the first preferred embodiment of the present invention.
Fig. 2A through Fig. 2F are sectional views showing the circuit board manufacturing method in the second preferred embodiment of the present invention.
Fig. 3 is a graph showing the change in thickness of a metal plate in the circuit board manufacturing method in the first preferred embodiment of the present invention.
Fig. 4 is a schematic view for illustrating a hard coat layer forming means used for a metal plates used in the circuit board manufacturing method in the third preferred embodiment of the present invention.
Fig. 5 is a configuration diagram of an equipment for a conventional circuit board manufacturing method.
Fig. 6A and Fig. 6B show sectional views of a metal plate for a production of a conventional circuit board.

### DESCRIPTION OF THE PREFERRED EMBODIMENTS

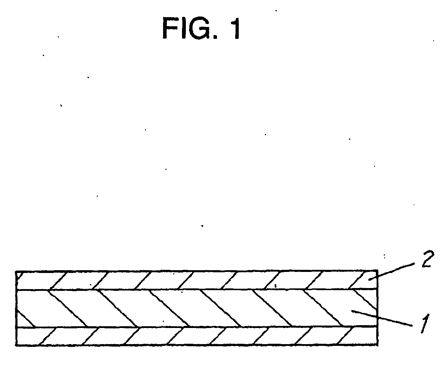

The preferred embodiments of the present invention will be described in the following with reference to Fig. 1 through Fig. 4.

### First Preferred Embodiment

Fig. 1 is a sectional view of a metal plate used in a method of manufacturing a circuit board in the first preferred embodiment of the present invention.

First, hard coat layer 2 is formed on both surfaces of a metal plate 1 made of stainless steel having a thickness of 1 mm. In the present preferred embodiment, the hard coat layer 2 is formed by using a so-called nitriding process wherein nitrogen atom is diffused into the stainless steel surface.

A wet process such as a salt bath method or the like is also well known as a nitriding process, but a gas nitriding process is employed in the present preferred embodiment.

A gas nitriding process is a preferable treatment method since the hard coat layer 2 is required to have a dense structure and an internal uniformity as well as a hardness.

Also, in order to obtain a preferable layer, it is necessary to fulfill the condition that the surface of the metal plate 1 is free from oxide layer during nitriding treatment. As a method of removing oxide layer, a fluoride layer is formed on the metal plate surface by heating the metal plate in a gas containing NF₃ before nitriding treatment, then, the metal plate 1 is heated in a gas containing NH₃ to form a nitride layer on the metal plate surface.

In the inventor's experiment, as a process for forming the fluoride layer before nitriding treatment, the NV super-nitriding process of Daido Hokusan Co., Ltd. was employed for the treatment, obtaining excellent results.

The layer thickness of the hard coat layer 2 is preferably to be 10 µm or more in the production of the circuit boards, though, it depends upon the structure of the hard coat layer 2 and a material quality of the metal plate 1.

If the thickness of the hard layer 2 is too thick, it will become difficult to remove the hard coat layer 2 when re-polishing and re-using the metal plate with the hard coat layer 2 formed thereon. Also, from the viewpoint of the cost, in the case of the nitriding treatment as described above, the layer thickness is preferably to be less than 100 µm, and more preferable to be less than 50 µm.

In order to make the best use of the present invention, as for the surface roughness (JIS B0601) of the hard layer 2 is preferable to have an average surface roughness Ra of 0.1 µm or less and maximum surface roughness Rmax of 2 µm or less, and more preferably, Ra of 0.05 µm or less and Rmax of 1 µm or less.

In order to obtain such a smoothness, it is desirable to finish the surface of the metal plate 1 before forming the hard coat layer 2 nearly as smooth as the final hard coat layer surface roughness, and is also preferable to finish the metal plate 1 by using a polishing means such as a polishing buff or brush of grain size of #700 or more.

The particle diameter of a grain used for a polishing means of No. 700 or like is usually about 30 µm, and in order to make use of the advantage of the present invention, a metal plate surface that is extremely excellent in surface smoothness can be obtained by using a polishing means of grain size of #1000 or more.

The above surface finishing conditions can be freely selected according to the type of circuit board obtained, the production cost, productivity and the like. Further, as for the metal plate surface polishing conditions, it is also possible to obtain a surface smoothness by executing similar finish polishing to the surface of the hard coat layer 2.

However, since the hard coat layer 2 is abrasion-resistant and poor in polishing workability, it is efficient to polish the metal plate 1 up to the desired smoothness before hard coat layer forming, and, after forming hard coat layer, to polish a slight amount to obtain the desired smoothness.

### Second Preferred Embodiment

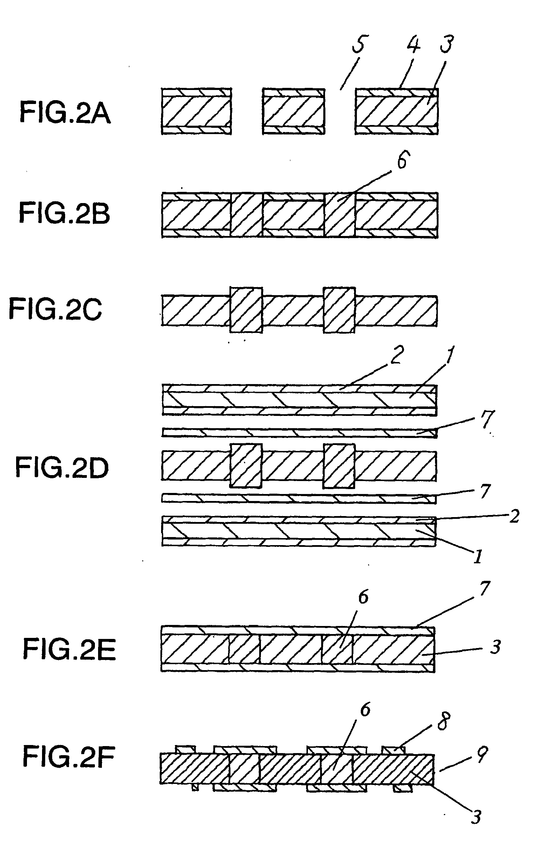

Fig. 2A through Fig. 2F are sectional views of a process, showing the circuit board manufacturing method in the second preferred embodiment of the present invention.

As shown in Fig. 2A, films 4 is temporarily pressed by a roll laminating method or the like onto a board material 3 formed of prepreg sheet whose reinforce material is impregnated with B-stage thermosetting resin. Then, through-holes 5 are formed in the board material by a drilling means using a laser beam.

In the present preferred embodiment, aramid fiber non-woven fabric is used as a reinforce material, a thickness of the board material 3 is about 130 µm, a diameter of the through-hole 5 is about 150 µm, and a thickness of the film 4 is about 20 µm.

Next, as shown in Fig. 2B, after filling conductive paste 6 into the through-holes 5 by a printing method or the like, the film 4 is peeled off as shown in Fig. 2C to obtain an intermediate material where the conductive paste 6 is slightly protruded from the board material 3.

Next, as shown in Fig. 2D, metal plates 1 with hard layers 2 formed thereon, copper foils 7 of 15 m in thickness, and the intermediate material are laminated and then heat pressed in the a heat press process, thereby obtaining a double-sided copper clad laminate as shown in Fig. 2E.

Also, the thickness of the copper foil is not limited to 15 µm, but less expensive copper foil of 35 µm in thickness can be used when fine wiring is not required. When wiring of very high precision is required, copper foil of 8 µm or less in thickness, 3 µm for example, can be used. The present invention is suited for a high precision circuit board using thin foils in particular.

The conditions for the heat press process are a 3-hour program including the temperature rise and temperature fall with one hour keeping at 180 °C peak temperature, and 300N pressure applied per one square centimeter.

The board material 3 is compressed in the heat press process and becomes about 110 µm in thickness. At this stage, the conductive paste 6 is compressed in the direction of thickness of board material 3, then the copper foils 7 on either surface of the board material are electrically connected to each other. After that, copper foils 7 are selectively etched to form circuit patterns, and thereby, a circuit board 9 with circuit patterns 8 formed on either surface thereof can be obtained as shown in Fig. 2F.

In the production of the circuit board in the present preferred embodiment, as described above, besides copper foil having a conventional thickness, copper foils of 20 µm or less in thickness are used as the metal foil, but it is also possible to use copper foils with a different material coated on the surface thereof or metal foils other than copper foils.

As in the process of the present preferred embodiment described above, since the hard coat layer 2 is formed on the surface of the metal plate 1, and moreover, the surface is smoothly finished, it is possible to apply pressures without damaging the copper foil 7 in the heat press process. Particularly; when a surface of the copper foil 7 is roughened, little damage will be given to the surface.

In the present preferred embodiment, efficient compressing of the conductive paste 6 is a inevitable condition for reliably forming the electrical connection of the circuit board. As a mechanical rigidity of the metal plate 1 is considerably enhanced due to the effect of the hard coat layer 2, and the deformation of metal plate 1 is very little during compression, it is possible to effectively compress the conductive paste 6.

In order to achieve the above purpose, the thickness of hard layer 2 is preferable to be 10 µm or more, and the surface of hard coat layer 2 is preferable to have 500 HV or more in Vickers hardness, and also, the hardness of the metal plate 1 itself is preferable to be 300 HV or more.

In the present preferred embodiment, the metal plate 1 is also subjected to a surface cleaning by a cleaning device after the heat press process the same as in a conventional circuit board manufacturing method. But, it is very easy to remove contamination or sticking matter due to the effect of the hard coat layer 2 that is the feature of the present invention. Accordingly, sticking matter can be easily removed by slightly rubbing the surface with a polishing buff of #1000 or more.

Also, the thickness of the metal plate 1 hardly changes after being passed a plurality of times through the cleaning device.

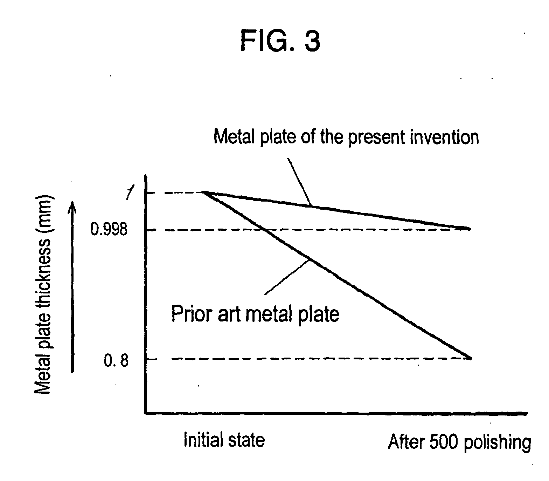

Fig. 3 shows the change in thickness of the metal plate 1 including the hard coat layer 2 when the metal plate 1 has been passed through the cleaning device up to 500 times.

The rate of change in plate thickness varies with the condition setting or the like of the metal plate cleaning device. When a stainless steel plate of 1 mm thick and having hard coat layers 2 of 15 µm thick formed by nitriding treatment is passed through a cleaning device using a polishing buff of #1000, the plate thickness is changed by about 2 µm after 500 times of the polishing.

That is, the amount of abrasion due to the polishing is 1 µm on each surface. From this result, in a simplified calculation, when a hard coat layer of 15 µm is formed, the entire hard layer wears out after 75,000 times of polishing, meaning the termination of its life. However, as a result of the inventor's experiment, the hard coat layer was able to endure at least more than 10,000 times of polishing.

To have a lifetime of this level is enough as a metal plate for the circuit board production, and in case the hard coat layer is worn out and gone, it can be regenerated by forming a hard coat layer again.

Shown in Fig. 3 is an comparative example of change in plate thickness when stainless steel plate (surface hardness: 350 HV) of 1 mm thick not provided with hard coat layer and used in a conventional circuit board manufacturing method is passed through a cleaning device using a polishing buff of #320, where the plate is reduced in thickness by about 200 µm after 500 times of polishing.

This value of reduction in plate thickness is not allowable in the production of the circuit boards. When such a stainless steel sheet of 1 mm thick is used as the metal plate, it can be concluded that 500 times of polishing will terminate the life of the metal plate. Accordingly, metal plates have been conventionally disposed when the number of polishing, or the using in the heat press process, exceeds 500 times.

Also, if a polishing buff of grain No. of #600 or more is used to suppress the reduction in plate thickness, it will result in lowering of the polishing ability and become unable to remove contamination such as resin sticking to the metal plate surface.

Further, even when the surface of the conventional metal plate is finished very smoothly as in the present invention for the purpose of improving the ability to remove contamination, only several times of using in the heat press process will generates fine scratches on the surface, which affects the surface smoothness, because the surface of the metal plate is insufficient in hardness.

As described above, it is difficult to improve the life of a conventional metal plate due to the abrasion. Also, if the polishing buff is not adequately maintained, even less than 500 times of polishing may cause the metal plate to include variations in thickness and the metal plate become unusable.

As for the metal plate for the production of the circuit boards of the present invention, the metal plate surface is hardly scratched and also can be kept clean since a hard coat layer is formed on the surface of the metal plate. Accordingly, it is possible to produce a high quality circuit board by using the metal plate of the present invention.

Also, a double-sided circuit board is described in the present preferred embodiment, but it is possible to manufacture a multi-layered circuit board by the process described above, with a double-sided circuit board or multi-layered circuit board disposed at the middle and with prepreg sheets and copper foils disposed at either outside thereof.

In the present preferred embodiment, a heat press process for heating and pressing the board material is described, and it is also effective for a process in which a heating or a pressing is individually performed, or a board material is heated under lower pressure.

That is, in the production of the circuit boards, it is effective to use metal plates provided with a hard coat layer, that is the feature of this invention, even in a heating process for eliminating moisture in the completed board, and in a warp correcting process or the like in which, in order to flatten the board, the circuit boards are kept between metal plates and pressed with a weak pressure of about several Newtons per square centimeter or only with the weight of the metal plate at a temperature exceeding the glass transition temperature of the board material.

Even in such processes, there may arise a problem that the surface smoothness of the metal plate is affected by volatile materials or the like which evaporate from the board during heating and stick to the metal plate. However, when the metal plate for the manufacture of circuit boards in the present invention is used in such processes, it is possible to remove volatile materials or the like, evaporated from the board, easily from the metal plate surface. Further, as the metal plate surface is smooth enough, a good effect that the circuit board surface is hardly damaged is obtained.

### Third Preferred Embodiment

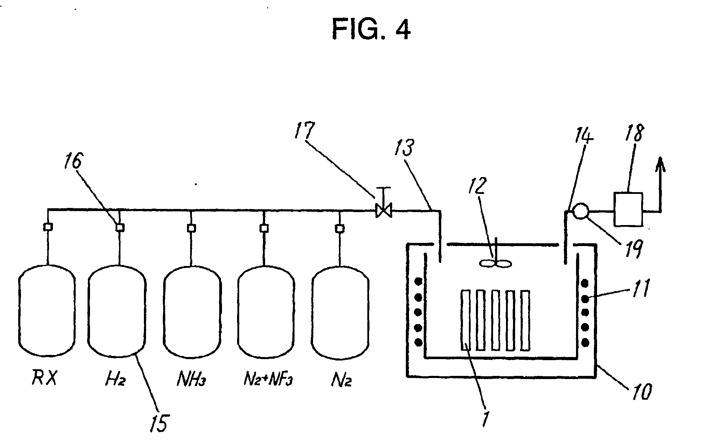

Fig. 4 is a schematic process diagram describing a hard layer forming means for a metal plate used in the circuit board manufacturing method of the present invention.

As shown in Fig. 4, heat treatment furnace 10 is of double structure in which heater 11 is disposed.

Gas intake pipe 13 and exhaust pipe 14 are connected to an inside of the heat treatment furnace 10 in which is installed a fan 12 for making the internal atmosphere uniform.

The gas intake pipe 13 is connected via valve 16 and flow meter 17 to a cylinder 15 for supplying various kinds of gas.

Also, vacuum pump 19 and exhaust gas treatment device 18 are connected to the exhaust pipe.

Metal plate 1 to be treated to have hard coat layer is disposed in the heat treatment furnace 10 by means of a proper holding jig (not shown).

A hard coat layer forming method will be briefly described in the following. After a fleon-cleaning of a plate material (1 mm thick) of SUS304 as a metal plate 1, whose surface is polished to 0.1 µm or less of average surface roughness Ra, the metal plate 1 is put into the heat treatment furnace 10 and is kept in a N₂ gas atmosphere containing 5,000 ppm NF₃ at 280 °C for 15 minutes.

After that, the temperature is raised to 470 ° C, and the metal plate is kept in an atmosphere of a mixed gas (10 %N₂ + 90 %H₂) for 30 minutes, and then is subjected to nitriding treatment for 8 hours in a mixed gas (20 %NH₃ + 80 %RX). As a carbon atom source in RX, it is preferable to use a paraffinic hydrocarbon gas such as methane, ethane, and propane and the like, but it is not limited to such gas, and any type of gas can be used if the gas contains carbon atom.

Through the above treatment, nitride layer (hard coat layer) of about 20 µm in thickness is uniformly formed on a surface of the metal plate 1. In the treatment method of the present preferred embodiment, oxide or the like on the surface of the metal plate 1 is once fluorinated into a fluoride layer and then the fluoride layer is changed to formed a nitride layer, therefore it is possible to assure the uniformity of the nitride layer. In addition, since the treatment temperature is low, there are advantages that the surface smoothness of the metal plate 1 smoothly polished before forming the hard coat layer is not affected and a thermal strain hardly occur in the metal plate 1.

In the present preferred embodiment, the treatment temperature is 470 °C, but it is also possible to treat at 400 °C or less depending upon the condition of nitriding to form a more preferable hard coat layer.

In each of the preferred embodiment of the present invention, the nitriding method is employed for forming the hard coat layer. However, various methods other than the nitriding method are available for the treatment to obtain the smoothness and hardness of the metal plate surface needed in the present invention. The advantages of the present invention may be obtained by selecting a method of treating the metal plate according to the types of circuit board and metal foil or the conditions for the heat press process.

For example, a surface treating method that is called carbonizing is available as a method in which carbon atom is diffused on the surface of steel material to form a hard coat layer. The surface hardness then obtained is 650 to 850 HV, a little lower than the hardness obtained in the nitriding method, but the hard coat layer may be increased as thick as from 0.1 to 2 mm to obtain a metal plate surface substantially very high in rigidity. Accordingly, it is possible to obtain an excellent result by applying the surface treatment in the present invention according to the purpose of the circuit board.

Also, a method in which both of carbon atom and nitrogen atom are diffused on the surface of the metal plate, that is called a carbonitriding method, is preferable for the treatment of a metal plate having an austenite phase.

As described above, however, the lower the temperature in forming a hard coat layer, the better for keeping the surface smoothness of the metal plate, and the metal plate is less strained, and therefore, it is effective to lower the treatment temperature as low as possible.

In the above method, a hard coat layer is formed on a metal plate by diffusing an element such as nitrogen atoms or carbon atoms on the surface thereof. It is also possible to employ a method in which a metal or the like completely different materials from the metal plate is formed as a hard coat layer by a vacuum deposition, a sputtering, a deposition or a plating.

Although there are many materials which can be used in the present method, metal nitride is most effective as a hard coat layer in the present invention because of its hardness. And, especially, nitride of titanium or titanium-based metal, that is so-called titanium nitride, is excellent in hardness and adhesion to the stainless steel.

Also, in a case diamond-like carbon thin film is formed on the surface of a metal plate, it is preferable with respect to the surface hardness, an excellence in sliding ability because of its small friction coefficient, and an advantage such that the metal plate surface is hard to be scratched while the metal plate is conveyed during the process.

Further, as for the diamond-like carbon thin film, in a case the film is not electro-conductive, it is effective to be used in a method where a heat source is obtained by applying an electric current to the copper foils in a heat press process, that is, a method in which the metal plate in the present invention is required to be not electro-conductive.

A similar effect can also be obtained, naturally, when non-electro-conductive thin film other than the diamond-like carbon film is used.

In each of the preferred embodiment of this invention, the description is made in the case of using the stainless steel plates as the metal plate material, but it is also possible to use a conventional steel material or a non-ferrous metal such as titanium, aluminum and the like as a metal plate.

Thus, the method of manufacturing circuit board in the present invention includes a heat press process in which a laminate with metal foil disposed on both surfaces or one surface of a board material or a board material with metal foil circuit formed thereon is held between metal plates and subjected to a heat press process under at least one of heat and pressing. In the heat press process, it is configured that a hard coat layer is formed on one surface or on both surfaces of the metal plate. Thus, it is possible to prevent the metal plate surface from being scratched by the existence of the hard coat layer and also to use the metal plate reliably for a long period of time in the circuit board manufacturing process, because the metal plate is less in the amount of abrasion in the cleaning and polishing process.

Also, since the metal plate surface is smoothly finished, it is easy to remove contamination such as resins sticking to the metal plate, and it is possible to assure the smoothness for a long period of time because the metal plate surface is very high in hardness.

When the manufacturing process further includes a step of conductive paste compression process or the like, the conductive paste is efficiently compressed since the metal plate has high rigidity, and an improvement of electrical connection reliability between the circuit layers of the circuit board is obtained.

### INDUSTRIAL APPLICABILITY

As described above, the present invention is capable of improving the durability of the metal plate by forming a hard coat layer on the metal plate surface used in the circuit board production, and also able to enhance the smoothness of the surface of the circuit board. Accordingly, the present invention is appropriate for the production of the high-quality and highly reliable circuit boards, high density circuit boards in particular.

## Claims

1. A method of manufacturing circuit board comprising:
holding a laminate between metal plates provided with hard coat layer on at least one surface thereof, said laminate comprising metal foil or resin-coated metal foil disposed on both surfaces or on one surface of a board material or board material with circuit formed thereon; and
pressing said laminate by applying at least one of heat and pressure.

2. The method of manufacturing circuit board of claim 1, wherein said metal plate is made of one of iron and a material mainly including iron.

3. The method of manufacturing circuit board of claim 1, wherein said metal plate is made of a stainless steel.

4. The method of manufacturing circuit board of any one of claims 1, 2 and 3, wherein said metal plate is made of a material having a Vickers hardness of 300 HV or more.

5. The method of manufacturing circuit board of claim 1, wherein said hard coat layer is formed by implanting or diffusing an element different from main material of the metal plate onto the surface of said metal plate.

6. The method of manufacturing circuit board of claim 5, wherein said element is one selected from the group consisting of nitrogen, carbon, and boron.

7. The method of manufacturing circuit board of claim 1, wherein said hard coat layer is formed by at least one treatment selected from the group consisting of carbonizing, nitriding, and carbonitriding.

8. The method of manufacturing circuit board of claim 5 or 7, wherein the method further comprises forming a metal fluoride layer on said metal plate surface prior to the implanting or the diffusing said element on the metal plate surface.

9. The method of manufacturing circuit board of claim 1, wherein said hard coat layer is a formed on the metal plate surface by one of a vacuum deposition, a sputtering, a deposition and a plating.

10. The method of manufacturing circuit board of claim 9, wherein said hard coat layer is made of a metal nitride.

11. The method of manufacturing circuit board of claim 10, wherein said metal for forming said metal nitride is titanium or a compound mainly containing titanium.

12. The method of manufacturing circuit board of claim 9, wherein said hard coat layer is made of a diamond-like carbon.

13. The method of manufacturing circuit board of claim 1, wherein said hard layer is 10 µm or more in thickness.

14. The method of manufacturing circuit board of claim 1, wherein a surface hardness of said hard coat layer is 500 HV or more in Vickers hardness.

15. The method of manufacturing circuit board of claim 1, wherein an average surface roughness Ra of said hard coat layer surface or said metal plate surface is 0.1 µm or less, where the average surface roughness Ra is defined in JIS B0601.

16. The method of manufacturing circuit board of claim 1, wherein a maximum surface roughness Rmax of said hard coat layer surface or said metal plate surface is 0.1 µm or less, where the maximum surface roughness Rmax is defined in JIS B0601.

17. The method of manufacturing circuit board of claim 1, wherein both surfaces or one surface of said metal foil is roughened, and a 10-point average surface roughness Rz is 5 µm or more, where the 10-point average surface roughness Rz is defined in JIS B0601.

18. The method of manufacturing circuit board of claim 1, wherein said metal foil is 20 µm or less in thickness.

19. The method of manufacturing circuit board of claim 1, further comprising cleaning of said metal plate after said pressing, wherein in said metal plate cleaning, at least one polishing means is used, and a grain size used for all polishing means or at least one for final polishing means has a grain size No. of #800 or more, or the average diameter of grain is 20 µm or less.

20. A method of manufacturing circuit board comprising:
holding a laminate between metal plates, said laminate comprising metal foil or resin-coated metal foil disposed on both surfaces or on one surface of a board material or board material with circuit formed thereon;
pressing said laminate by applying at least one of heat and pressure; and
cleaning of said metal plate after said pressing, wherein in said metal plate cleaning, at least one polishing means is used, and a grain size used for all polishing means or at least one for final polishing means has a grain size No. of #800 or more, or the average diameter of grain is 20 µm or less.
